# EUROPEAN PATENT SPECIFICATION

(11) **EP 3 488 469 B1**
(45) Date of publication and mention of the grant of the patent: **16.10.2024**
(21) Application number: 17768339.8
(22) Date of filing: 08.03.2017
(51) Int. Cl.: H10K 59/35, G09G 3/3225

(54) **PIXEL ARRANGEMENT STRUCTURE, DISPLAY SUBSTRATE, DISPLAY APPARATUS AND METHOD OF FABRICATION THEREOF**
PIXELANORDNUNGSSTRUKTUR, ANZEIGESUBSTRAT, ANZEIGEVORRICHTUNG UND VERFAHREN ZUR HERSTELLUNG DAVON
STRUCTURE D'AGENCEMENT DE PIXELS, SUBSTRAT D'AFFICHAGE, APPAREIL D'AFFICHAGE ET LEUR PROCÉDÉ DE FABRICATION

(30) Priority: 22.07.2016 CN 201610585894
(43) Date of publication of application: 29.05.2019
(73) Proprietor: BOE Technology Group Co., Ltd., Beijing 100015 (CN)
(72) Inventor: JIN, Xiaodan, Beijing 100176 (CN); HUANGFU, Lujiang, Beijing 100176 (CN); LIANG, Yinan, Beijing 100176 (CN)
(74) Representative: AWA Sweden AB
(86) International application number: PCT/CN2017/075957
(87) International publication number: WO 2018/014562

(56) References cited:
- EP-A1- 2 680 310
- CN-A- 104 332 486
- CN-A- 104 597 655
- CN-U- 205 231 065
- CN-U- 205 355 055
- CN-U- 205 845 956
- US-A1- 2014 252 321
- US-A1- 2015 162 394
- US-A1- 2016 126 296
- US-A1- 2016 357 076

## Description

### CROSS-REFERENCE TO RELATED APPLICATIONS

This application claims the benefit of the filing date of Chinese Patent Application No. 201610585894.4 filed on July 22, 2016.

### TECHNICAL FIELD

This invention relates to a display technology, and more particularly, to a pixel arrangement structure, display substrate, display device, and method of manufacturing thereof.

### BACKGROUND

The requirement that display devices have high display resolution increases the difficulty of manufacturing and cost of the display device. In particular, in the present AMOLED (Active Matrix Organic Light-Emitting Diode) field, due to the limitations of the FMM (Fine Metal Mask) technology, it is difficult to produce a high PPI (Pixel per inch, pixel density) display device.

Three sub-pixels RGB are to be arranged within a pixel spacing in the direction perpendicular to the direction of the stripe sub-pixel in a pixel made of stripe RGB sub-pixels (stripe RGB). As such, when pixel density is greater than 300 ppi, it is very difficult for the present FMM process to achieve the desired pixel density.

### BRIEF SUMMARY

The invention is defined in the appended claims.

US 2016/126296 A1, EP 2 680 310 A1 , CN 104 597 655 A, US 2014/252321 A1 and CN 205 355 055 U disclose devices according to the preamble of claim 1.

### BRIEF DESCRIPTION OF THE DRAWINGS

The foregoing and other objects, features, and advantages of the invention are apparent from the following detailed description taken in conjunction with the accompanying drawings in which:
Fig. 1 shows a schematic view of a pixel arrangement structure according to one embodiment.
Fig. 2 shows a schematic view of a pixel arrangement structure according to one embodiment.
Fig. 3 shows a schematic view of a pixel arrangement structure according to one embodiment.
Fig. 4 shows a schematic view of a pixel arrangement structure according to one embodiment.

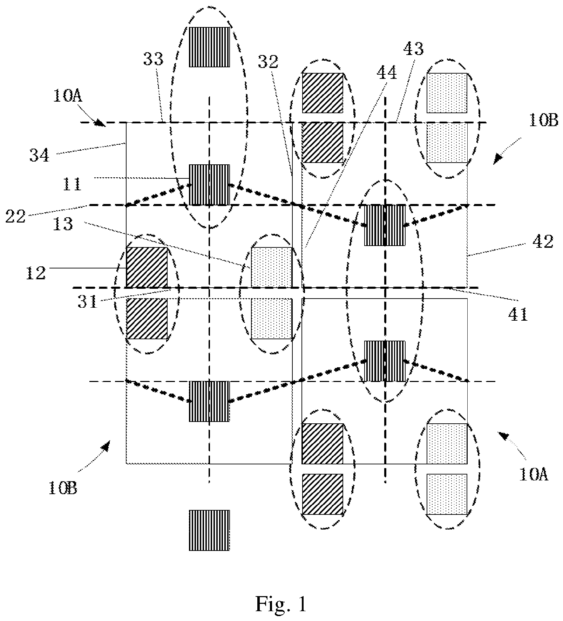

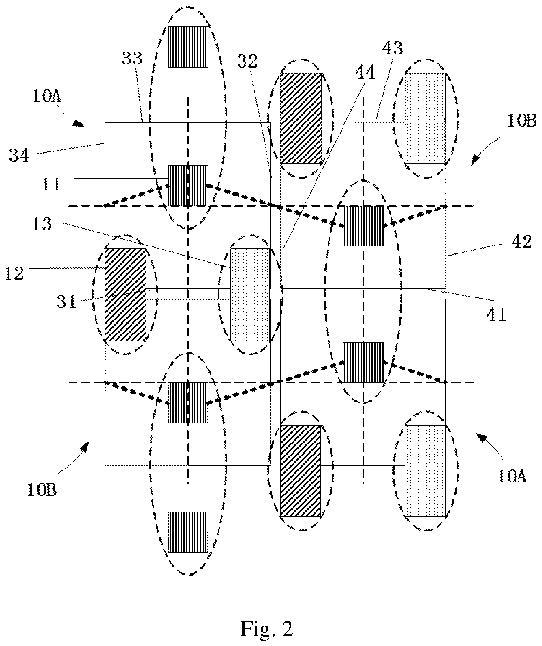

From the above mentioned embodiments that corresponding to figure 2 is an embodiment of the present invention. The embodiments of figures 1, 3 and 4 do not form part of the present invention but are useful to understand it.

### DETAILED DESCRIPTION

Reference is made to Figures 1-3. When referring to the figures, like structures and elements shown throughout are indicated with like reference numerals.

Unless otherwise defined, technical terms or scientific terms used herein should be in the ordinary meaning as understood by those of ordinary skill in the art to which this invention belongs. The terms "first," "second," and the like as used in the specification and claims are not intended to imply any order, quantity or importance, but only to distinguish between the different components. Likewise, the terms "a" and the like do not denote a numerical limitation, but rather denote the presence of at least one. The terms "connected" and the like are not limited to physical or mechanical connections, regardless of whether it is direct or indirect. The terms "upper," "lower," "left," "right" and the like are used only to indicate a relative positional relationship. When the absolute position of the described object is changed, the relative positional relationship is also changed accordingly.

Fig. 1 shows a schematic view of a pixel arrangement structure in accordance with some embodiments of the present disclosure. The pixel arrangement structure comprises: a plurality of first pixels 10A and a plurality of second pixels 10B. The first pixel 10A and the second pixel 10B are alternately arranged in a row direction and a column direction. All pixels surrounding a first pixel 10A are second pixels, and all pixels surrounding a second pixel 10B are first pixels. That is, except pixels at the edges, each of the first pixels is surrounded by the second pixels, and each of the second pixels is surrounded by the first pixels. The first pixel has a first side 31, a second side 32, a third side 33 opposite the first side 31, and a fourth side 34 opposite the second side 32. The second pixel has a first side 41, a second side 42, a third side 43 opposite the first side 41, and a fourth side 44 opposite the second side 42. Each of the first pixel 10A and the second pixel 10B includes: a first sub-pixel 11, a second sub-pixel 12, and a third subpixel 13.

In one embodiment, the first sub-pixel 11, the second sub-pixel 12, and the third sub-pixel 13 in the first pixel 10A form a triangular distribution. The first sub-pixel 11, the second sub-pixel 12, and the third sub-pixel 13 in the second pixel 10B form an inverted triangular distribution relative to the triangular distribution in the first pixel. The second sub-pixel and the third sub-pixel in each of the first pixel and the second pixel are located on substantially the same row. "Located on substantially the same row" means that an acute angle formed between a line connecting centers of the second sub-pixel and the third sub-pixel and the row direction is smaller than 5 degree.

In one embodiment, the first sub-pixel in the first pixel is at a center region of the first pixel. The first sub-pixel in the second pixel is at a center region of the second pixel. The "center region" means that the center of the first pixel or the second pixel is located at one part of the first sub-pixel of the first pixel or the second pixel respectively.

In one embodiment, the first sub-pixel is a green sub-pixel.

In one embodiment, the second sub-pixel and the third sub-pixel in each of the first pixel and the second pixel are at an edge region of the pixel.

In one embodiment, in the first pixel, an edge of the second sub-pixel 12 and an edge of the third sub-pixel 13 opposite to the first sub-pixel 11 are in close proximity to the first side 31 of the first pixel 10A. "In close proximity to" herein means that a vertical distance from a center of the second sub-pixel to the first side 31is smaller than a length of a vertical side of the second sub-pixel, and a vertical distance from a center of the third sub-pixel to the first side is smaller than a length of a vertical side of the third sub-pixel.

In the second pixel adjacent to the first pixel in the row direction, an edge of the second sub-pixel 12 and an edge of the third sub-pixel 13 opposite to the first subpixel 11 are in close proximity to the third side 43 of the second pixel 10B. "In close proximity to" herein means that a vertical distance from a center of the second sub-pixel to the third side 43 is smaller than a length of a vertical side of the second sub-pixel, and a vertical distance from a center of the third sub-pixel to the third side 43 is smaller than a length of a vertical side of the third sub-pixel.

The first side 31 of the first pixel 10A and the third side 43 of the second pixel 10B are located on two opposite sides of the first sub-pixels of the first pixel 10A and the second pixel 10B respectively. In the first pixel 10A, the first sub-pixel is within a region between the third side 33 and the second and third sub-pixels. In the second pixel, the first sub-pixel is within a region between the first side 41 and the second and third sub-pixels.

In one embodiment, the edge of the second sub-pixel and the edge of the third sub-pixel opposite to the first sub-pixel in the first pixel overlap with the first side 31. The edge of the second sub-pixel and the edge of the third sub-pixel in the second pixel overlap with the third side 43.

In one embodiment, in the first pixel 10A, a vertical distance from a center of the first sub-pixel to the third side 33 is smaller than a vertical distance from the center of the first sub-pixel to the first side 31. In the second pixel, a vertical distance from a center of the first sub-pixel to the first side 41 is smaller than a vertical distance from the center of the first sub-pixel to the third side 43.

In one embodiment, in each of the first pixel and the second pixel, an edge of the first sub-pixel adjacent to the second sub-pixel and the third sub-pixel is in close proximity to a second straight line 22, which is parallel to the row direction and at equal vertical distance to the first side and the third side. "In close proximity to" herein means that a vertical distance from a center of the first sub-pixel to the second straight line 22 is smaller than a length of a vertical side of the first sub-pixel.

In one embodiment, the edge of the first sub-pixel adjacent to the second sub-pixel and the third sub-pixel overlap with the second straight line 22.

In one embodiment, the first sub-pixel, the second sub-pixel, and the third sub-pixel of the same pixel form an isosceles triangle distribution. Each of the first pixel and the second pixel may be a rectangular or square pixel.

In one embodiment, in each of the first pixel and the second pixel, the second sub-pixel and the third sub-pixel are located near two corners of the rectangular or square pixel in the row direction, with two adjacent perpendicular edges of the second sub-pixel and two adjacent perpendicular edges of the third sub-pixel in close proximity to two adjacent perpendicular edges of the rectangular or square pixel, respectively. "In close proximity to" herein means that a vertical distance from a center of a sub-pixel to a side of the pixel is smaller than a length of a perpendicular side of the sub-pixel, which is perpendicular to the side of the pixel,

In one embodiment, the two adjacent perpendicular edges of the second sub-pixel and the two adjacent perpendicular edges of the third sub-pixel overlap with the two adjacent perpendicular edges of the rectangular or square pixel, respectively.

In one embodiment, in each of the first pixel and the second pixel, the first sub-pixel is positioned on a perpendicular bisector of the second sub-pixel and the third sub-pixel. In another embodiment, in each of the first pixel and the second pixel, a center of the first sub-pixel is located on the perpendicular bisector of the second sub-pixel and the third sub-pixel.

In one embodiment, the second sub-pixel and third pixel in the first pixel are adjacent to the second sub-pixel and third pixel in the second pixel adjacent to the first pixel in the column direction.

In one embodiment, as shown in Fig. 1, in a row direction, three sub-pixels of different colors are arranged within a spacing of two adjacent pixels of the same row. In the column direction, two sub-pixels of the same color are arranged within a spacing of two adjacent pixels of the same column. Compared with the conventional art, where six sub-pixels are arranged within a spacing of two adjacent pixels in the row direction, and two sub-pixels are arranged within a spacing of two adjacent pixels in the column direction, this embodiment reduces the number of sub-pixels significantly, thereby reducing the difficulty of manufacturing the pixels, and making it possible to produce a display device having a high PPI (e.g., a resolution of 500ppi or more).

In one embodiment, in the same column, only two sub-pixels of the same color are included, and the two sub-pixels are adjacent to each other (see the two subpixels in the same elliptical dashed-line frame in Fig. 1. During the vapor deposition technique to form the sub-pixels in accordance with some embodiments, the number of sub-pixels within the spacing of the same number of pixels is reduced. The two adjacent sub-pixels located in the same elliptical dashed-line frame can be formed by one FMM opening evaporation. Accordingly, the number (density) of the FMM openings can be effectively reduced, thereby breaking through the limitation of the FMM technology for high-resolution AMOLED, and achieving 300ppi or higher resolution of AMOLED.

In one embodiment, the pixels in the pixel arrangement structure are Real (real) pixels. Accordingly, even in the high PPI, the graphical image display is still relatively clear. This is particularly important for some displays of special graphics or images. For example, displays of pointers of electronic display watches and other details show a smooth, sharp feeling.

In one embodiment, as shown in Fig. 1, in the same column, the adjacent first and second pixels 10A and 10B are mirror-symmetric. That is, the arrangement structure of the first sub-pixel 11, the second sub-pixel 12, and the third sub-pixel 13 in the second pixel 10B is mirror-symmetric with that of the first sub-pixel 11, the second sub-pixel 12, and the third sub-pixel in the first pixel 10A.

In one embodiment, in the same column, adjacent first and second pixels 10A and 10B are not mirror-symmetric; for example, the center of the first sub-pixel 11 of the first pixel 10A and the center of the first sub-pixel 11 of the second pixel 10B may not be on the same straight line.

In one embodiment, in the same pixel, the first sub-pixel 11, the second sub-pixel 12, and the third sub-pixel 13 have an isosceles triangle distribution. That is, the lines connecting the centers of the first sub-pixel 11, the second sub-pixel 12, and the third sub-pixel 13 form an isosceles triangle. In another embodiment, the first sub-pixel 11, the second sub-pixel 12, and the third sub-pixel 13 have an equilateral triangle distribution.

In one embodiment, in the column direction, a vertical distance from the first sub-pixel to a line connecting centers of the second sub-pixel or the third sub-pixel in the same pixel is larger than a vertical distance from the same first sub-pixel to a line connecting centers of another second sub-pixel and another third sub-pixel in another adjacent pixel in the row direction.

In one embodiment, in the same pixel, an edge of the first sub-pixel 11, which is parallel to the row direction and adjacent to the second sub-pixel 12 and the third sub-pixel 13, is located on a second straight line 22. In one embodiment, the second straight line 22 is parallel to the first side and located between the first side and the third side. In one embodiment, the distances from the second straight line 22 to the first side and to the third side are the same. The distance between two straight lines generally refers to the vertical distance between the two straight lines.

In one embodiment, the first sub-pixel 11, the second sub-pixel 12, and the third sub-pixel 13 are all rectangular sub-pixels. Based on actual needs of production, these sub-pixels may be formed into other shapes such as a circle, a triangle, a parallelogram, etc., and the present disclosure is not limited thereto.

In one embodiment, the first pixel 10A and the second pixel 10B each is a rectangular pixel. Preferably, the first pixel 10A and the second pixel 10B each is a square pixel, which makes the distribution of the sub-pixels more uniform and improves the quality of display. Based on actual production needs, other shapes such as a circle, a triangle, a parallelogram, and the like may also be made, and the present invention is not limited thereto.

In another embodiment, the first sub-pixel 11 is a sub-pixel having a larger impact on brightness of the pixel, and the second sub-pixel 12 and the third sub-pixel 13 are sub-pixels having a smaller impact on brightness of the pixel. That is, the impact on brightness of the pixel by the first sub-pixel 11 in the pixel is larger than that of the second sub-pixel 12 and the third sub-pixel 13 in the pixel, thereby making the brightness distribution of the pixels more uniform, and improving the display quality of the display device.

In one embodiment, in the same pixel, the second sub-pixel 12 and the third sub-pixel 13 are located at two ends of one side of the rectangular pixel. Preferably, two perpendicular edges of the second sub-pixel 12 and two perpendicular edges of the third sub-pixel 13 are in close proximity to two adjacent perpendicular edges of the pixel. In other embodiments, two perpendicular edges of the second sub-pixel 12 and two perpendicular edges of the third sub-pixel 13 completely overlap to two adjacent perpendicular edges of the pixel. In other embodiments of the present invention, there may be possibility of fine adjustment of the positions of the second sub-pixel 12 or the third sub-pixel 13.

In one embodiment, when the pixel is a rectangular pixel, in the same pixel, the first sub-pixel 11 is positioned on a perpendicular bisector between the second sub-pixel 12 and the third sub-pixel 13. Preferably, a center of the first sub-pixel 11 is located on the perpendicular bisector between the second sub-pixel 12 and the third subpixel 13.

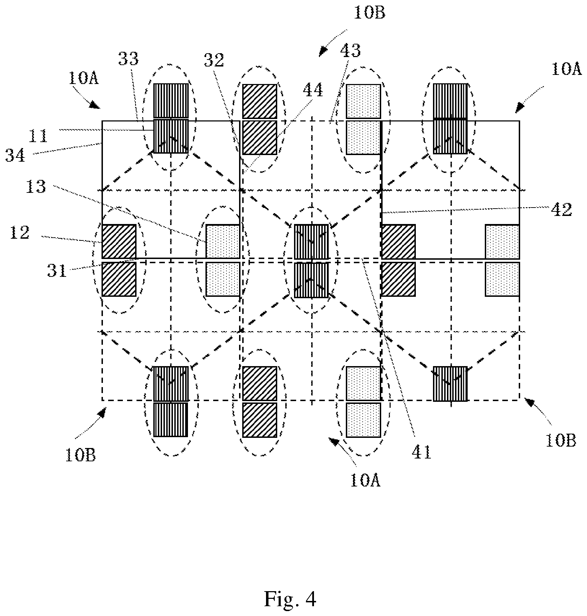

In one embodiment, in the first pixel, when the pixel is a rectangular pixel, the vertical distance from a center of the first sub-pixel 11 to the first side is larger than that from the center of the first sub-pixel 11 to the third side (contrast with the first side). In the second pixel adjacent to the first pixel, the distance from a center of the first subpixel 11 to the third side is larger than that from the center of first sub-pixel 11 to the first side. Accordingly, the first sub-pixel 11 is more uniformly distributed along the first pixel and the second pixel than the embodiment as shown in Fig. 4.

Fig. 4 shows a schematic view of a pixel arrangement structure in accordance with one embodiment not forming part of the present invention. In one embodiment, as shown in Fig. 4, in the first pixel, an edge of the first sub-pixel opposite to the second pixel and the third pixel overlaps with the third side 33. In the second pixel, an edge of the first sub-pixel opposite to the second pixel and the third pixel overlaps with the first side 41.

In one embodiment, in the same pixel, an edge of the first sub-pixel 11, which is parallel and adjacent to the first side, is in close proximity to the perpendicular bisector of the second side of the pixel. In other embodiments not forming part of the present invention, the first sub-pixel 11 may be provided at another position, such as other locations between the third side and the perpendicular bisector of the second side of the pixel.

As the human eye is more sensitive to green color, while not too sensitive to red and blue colors, in one embodiment, the first sub-pixel 11 is a green sub-pixel, the second sub-pixel 12 may be a red sub-pixel or a blue sub-pixel, and the third subpixel 13 may be a blue or red sub-pixel. The possibility of using sub-pixels of other colors is not excluded.

Fig. 2 shows a schematic view of a pixel arrangement structure in accordance with one embodiment of the present invention. This embodiment differs from the embodiment shown in Fig. 1 in that, in the same column, the second sub-pixels 12 and the third sub-pixels 13 of adjacent first and second pixels 10A and 10B, which are mirror-symmetrical, are integrated , which is then shared by the first pixel 10A and the second pixel 10B through Sup-Pixel Rendering (SPR) algorithm driving. The sharing means that the second sub-pixel 12 in the first pixel 10A and that in the second pixel 10B have a unitary structure. The third sub-pixel 13 in the first pixel 10A and that in the second pixel 10B have a unitary structure. But during display, one of ordinary skill in the art would understand that it is possible to separately control the light emission thereof.

The so-called SPR technology (derived from the virtual pixel reconstruction) refers to, when the display resolution level is equivalent to human eye resolution level, it is possible to utilize the difference in the resolution of the human eye with respect to sub-pixels of different colors to change the conventional model of the pixel (Pixel) simply defined by sub-pixels of three-colors, red, green, and blue (R, G, B). Different pixels also can share some sub-pixels having colors which are insensitive to location resolution. As such, it is possible to use a relatively smaller number of sub-pixels to imitatively achieve the same pixel resolution performance capabilities, thereby reducing the difficulty of processing and the cost.

In one embodiment, the second sub-pixels 12 located in the adjacent first and second pixels 10A and 10B respectively in the same column are integrated. The third sub-pixels 13 located in the adjacent first and second pixels 10A and 10B respectively in the same column are integrated. In another embodiment, only one pair of the first and second sub-pixels 12 or third sub-pixels 13 in the adjacent first and second pixels 10A and 10B are merged into one pixel.

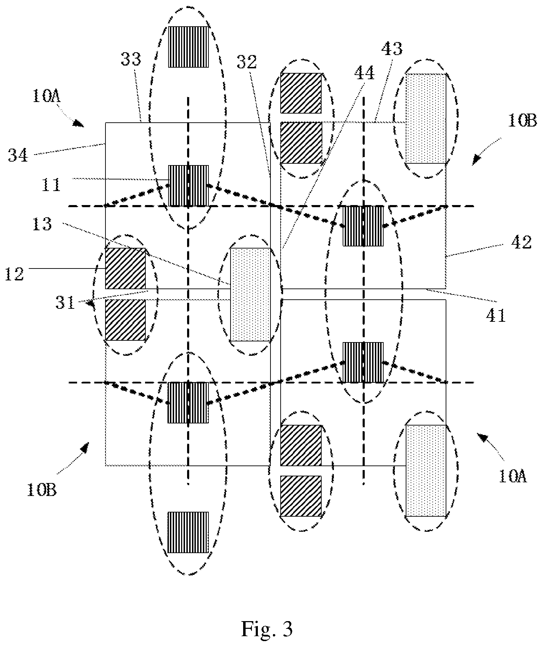

Fig. 3 shows a schematic view of a pixel arrangement structure in accordance with one embodiment of the present disclosure. This embodiment differs from the embodiment shown in Fig. 1 in that, in the same column, the third sub-pixels 13 in the adjacent first sub-pixel 10A and the second pixel 10B, which are mirror-symmetrical, in the same column are integrated, driven by the SPR algorithm and shared by the first pixel 10A and the second pixel 10B.

As the human eye is least sensitive to the blue color, it is preferable that the third sub-pixel 13 is a blue sub-pixel.

In another embodiment, the first sub-pixels in the adjacent first pixel and the second pixel in the same column may be shared as well, for example, the two first sub-pixels located in the same elliptical dotted circle in Fig. 3 may be shared.

The embodiment of the present invention also provides a display substrate, including the pixel arrangement structure of claim 1.

Preferably, the display substrate may be an OLED display substrate.

One embodiment of the present disclosure also provides a display device including the above-described display substrate.

According to one embodiment of the present disclosure a method of manufacturing a display substrate is also provided for producing the display substrate.

In the embodiment, the display substrate is an OLED display substrate, and the manufacturing method may include: forming a sub-pixel of the OLED display substrate by an evaporation deposition technology using an FMM mask plate. The FMM mask plate may include at least one first opening, and the first opening may correspond to at least two adjacent sub-pixels of the same color.

One embodiment of the disclosure also provides an FMM mask plate, which can be used to form the OLED display substrate. The FMM mask plate includes at least one first opening, and the first opening may correspond to at least two adjacent subpixels of the same color.

## Claims

1. A pixel arrangement structure, comprising:
a first pixel (10A) having a first side (31) and a third side (33) opposite the first side (31), and
a second pixel (10B) having a first side (41) and a third side (43) opposite the first side (41),
the first pixel (10A) and the second pixel (10B) each comprising:
a first sub-pixel (11),
a second sub-pixel (12), and
a third sub-pixel (13);
wherein the first pixel (10A) and the second pixel (10B) are alternately in a row direction and a column direction;
the first sub-pixel (11), the second sub-pixel (12), and the third sub-pixel (13) in the first pixel (10A) form a triangular distribution;
the first sub-pixel (11), the second sub-pixel (12), and the third sub-pixel (13) in the second pixel (10B) form an inverted triangular distribution relative to the triangular distribution in the first pixel (10A); and
the second sub-pixel (12) and the third sub-pixel (13) in the first pixel (10A) are located on substantially a same row, and the second sub-pixel (12) and the third sub-pixel (13) in the second pixel (10B) are located on substantially a same row; and
wherein
the second sub-pixel (12) and the third sub-pixel (13) in the first pixel (10A) are adjacent to the second sub-pixel (12) and the third sub-pixel (13) in the second pixel (10B) adjacent to the first pixel (10A) in the column direction respectively,
the second sub-pixel (12) in the first pixel (10A) and the second sub-pixel (12) in the second pixel (10B) adjacent to the first pixel (10A) in the column direction are integrated and shared by the first pixel (10A) and the second pixel (10B) adjacent to the first pixel (10A) in the column direction, such that the second sub-pixel (12) in the first pixel 10A and the second sub-pixel (12) in the second pixel (10B) adjacent to the first pixel (10A) in the column direction have a unitary structure; and the third sub-pixel (13) in the first pixel (10A) and the third sub-pixel (13) in the second pixel (10B) adjacent to the first pixel (10A) in the column direction are integrated and shared by the first pixel (10A) and the second pixel (10B) adjacent to the first pixel (10A) in the column direction, such that the third sub-pixel (13) in the first pixel 10A and the third sub-pixel (13) in the second pixel (10B) adjacent to the first pixel (10A) in the column direction have the unitary structure, and **characterized in that**
the pixel arrangement structure comprises a plurality of repeated units arranged in the row direction and the column direction, with each of the repeated units comprising two first sub-pixels (11), one second unitary sub-pixel and one third unitary sub-pixel; the two first sub-pixels (11) are in a column direction and form a first sub-pixel group; and the first sub-pixel group, the second unitary subpixel and the third unitary sub-pixel are in a row direction;
wherein the first sub-pixel (11) in each of the first pixel (10A) and the second pixel (10B) is at a center region of the pixel, and the first sub-pixel (11) in each of the first pixel (10A) and the second pixel (10B) is a green sub-pixel;
wherein a pixel region where each of the first pixel (10A) and the second pixel (10B) is located is a rectangular region, the first sub-pixel (11) in each of the first pixel (10A) and the second pixel (10B) covers a center of the rectangular region and a surrounding region of the center in the rectangular region.

2. The pixel arrangement structure according to claim 1, wherein the second sub-pixel (12) and the third sub-pixel (13) in each of the first pixel (10A) and the second pixel (10B) are located on the same row.

3. The pixel arrangement structure according to any one of claims 1-2, wherein the second sub-pixel (12) and the third sub-pixel (13) in each of the first pixel (10A) and the second pixel (10B) are at an edge region of the pixel.

4. The pixel arrangement structure according to any one of claims 1-3, wherein
in the first pixel (10A), an edge of the second sub-pixel (12) opposite to the first sub-pixel (11) and an edge of the third sub-pixel (13) opposite to the first sub-pixel (11) are in close proximity to the first side (31) of the first pixel (10A);
in the second pixel (10B) adjacent to the first pixel (10A) in the row direction, an edge of the second sub-pixel (12) opposite to the first sub-pixel (11) and an edge of the third sub-pixel (13) opposite to the first sub-pixel (11) are in close proximity to the third side (43) of the second pixel (10B);
the first side (31) of the first pixel (10A) and the third side (43) of the second pixel (10B) are located on two opposite sides of the first sub-pixels (11) of the first pixel (10A) and the second pixel (10B) respectively;
in the first pixel (10A), the first sub-pixel (11) is within a region between the third side (33) and the second and third sub-pixels (12, 13); and
in the second pixel (10B), the first sub-pixel (11) is within a region between the first side (41) and the second and third sub-pixels (12, 13),
preferably, the edge of the second sub-pixel (12) opposite to the first subpixel (11) and the edge of the third sub-pixel (13) opposite to the first sub-pixel (11) in the first pixel (10A) overlap with the first side (31); and
the edge of the second sub-pixel (12) opposite to the first sub-pixel (11) and the edge of the third sub-pixel (13) opposite to the first sub-pixel (11) in the second pixel (10B) overlap with the third side (43).

5. The pixel arrangement structure according to any one of claims 1-4, wherein:
in the first pixel (10A), a vertical distance from a center of the first subpixel (11) to the third side (33) is smaller than a vertical distance from the center of the first sub-pixel (11) to the first side (31); and
in the second pixel (10B), a vertical distance from a center of the first subpixel (11) to the first side (41) is smaller than a vertical distance from the center of the first sub-pixel (11) to the third side (43).

6. The pixel arrangement structure according to any one of claims 1-5, wherein in each of the first pixel (10A) and the second pixel (10B), an edge of the first sub-pixel (11) adjacent to the second sub-pixel (12) and the third sub-pixel (13) is in close proximity to a second straight line (22), the second straight line (22) being parallel to the row direction and at equal vertical distance to the first side (31, 41) and the third side (33, 43),
preferably, the edge of the first sub-pixel (11) adjacent to the second subpixel (12) and the third sub-pixel (13) overlap with the second straight line (22).

7. The pixel arrangement structure according to any one of claims 1-6, wherein the first sub-pixel (11), the second sub-pixel (12), and the third sub-pixel (13) of the same pixel (10A, 10B) form an isosceles triangle distribution.

8. The pixel arrangement structure according to any one of claims 1-7, wherein each of the first pixel (10A) and the second pixel (10B) is a rectangular or square pixel,
preferably, in each of the first pixel (10A) and the second pixel (10B), the second sub-pixel (12) and the third sub-pixel (13) are located near two corners of the rectangular or square pixel in the row direction, with two adjacent perpendicular edges of the second sub-pixel (12) and two adjacent perpendicular edges of the third sub-pixel (13) in close proximity to two adjacent perpendicular edges of the rectangular or square pixel, respectively,
preferably, the two adjacent perpendicular edges of the second sub-pixel (12) and the two adjacent perpendicular edges of the third sub-pixel (13) overlap with the two adjacent perpendicular edges of the rectangular or square pixel, respectively.

9. The pixel arrangement structure according to any one of claims 1-8, wherein the first sub-pixel (11) is positioned on a perpendicular bisector of the second sub-pixel (12) and the third sub-pixel (13),
preferably, a center of the first sub-pixel (11) is located on the perpendicular bisector of the second sub-pixel (12) and the third sub-pixel (13).

10. The pixel arrangement structure according to any one of claims 1-9, wherein each of the first sub-pixel (11), the second sub-pixel (12) and the third sub-pixel (13) is a rectangle or square sub-pixel.

11. The pixel arrangement structure according to any one of claims 1-10, wherein the first pixel (10A) and the second pixel (10B) adjacent to each other in a column direction are mirror-symmetric.

12. A display substrate, comprising the pixel arrangement structure of any one of claims 1-11.

## Patentansprüche

1. Pixelanordnungsstruktur, umfassend:
ein erstes Pixel (10A) mit einer ersten Seite (31) und einer dritten Seite (33), die der ersten Seite (31) gegenüberliegt, und
ein zweites Pixel (10B) mit einer ersten Seite (41) und einer dritten Seite (43), die der ersten Seite (41) gegenüberliegt,
wobei das erste Pixel (10A) und das zweite Pixel (10B) jeweils Folgendes umfassen:
ein erstes Subpixel (11),
ein zweites Subpixel (12) und
ein drittes Subpixel (13);
wobei sich das erste Pixel (10A) und das zweite Pixel (10B) abwechselnd in einer Zeilenrichtung und einer Spaltenrichtung befinden;
das erste Subpixel (11), das zweite Subpixel (12) und das dritte Subpixel (13) in dem ersten Pixel (10A) eine Dreiecksverteilung ausbilden;
das erste Subpixel (11), das zweite Subpixel (12) und das dritte Subpixel (13) in dem zweiten Pixel (10B) eine invertierte Dreiecksverteilung in Bezug auf die Dreiecksverteilung in dem ersten Pixel (10A) ausbilden; und
das zweite Subpixel (12) und das dritte Subpixel (13) in dem ersten Pixel (10A) im Wesentlichen in einer gleichen Zeile angeordnet sind und das zweite Subpixel (12) und das dritte Subpixel (13) in dem zweiten Pixel (10B) im Wesentlichen in einer gleichen Zeile angeordnet sind; und
wobei sich jeweils das zweite Subpixel (12) und das dritte Subpixel (13) in dem ersten Pixel (10A) benachbart zu dem zweiten Subpixel (12) befinden und sich das dritte Subpixel (13) in dem zweiten Pixel (10B) benachbart zu dem ersten Pixel (10A) in der Spaltenrichtung befindet,
das zweite Subpixel (12) in dem ersten Pixel (10A) und das zweite Subpixel (12) in dem zweiten Pixel (10B), das sich benachbart zu dem ersten Pixel (10A) in der Spaltenrichtung befindet, integriert sind und von dem ersten Pixel (10A) und dem zweiten Pixel (10B), das sich benachbart zu dem ersten Pixel (10A) in der Spaltenrichtung befindet, gemeinsam genutzt werden, so dass das zweite Subpixel (12) in dem ersten Pixel (10A) und das zweite Subpixel (12) in dem zweiten Pixel (10B), das sich benachbart zu dem ersten Pixel (10A) in der Spaltenrichtung befindet, eine einheitliche Struktur aufweisen; und das dritte Subpixel (13) in dem ersten Pixel (10A) und das dritte Subpixel (13) in dem zweiten Pixel (10B), das sich benachbart zu dem ersten Pixel (10A) in der Spaltenrichtung befindet, integriert sind und von dem ersten Pixel (10A) und dem zweiten Pixel (10B), das sich benachbart zu dem ersten Pixel (10A) in der Spaltenrichtung befindet, gemeinsam genutzt werden, so dass das dritte Subpixel (13) in dem ersten Pixel (10A) und das dritte Subpixel (13) in dem zweiten Pixel (10B), das sich benachbart zu dem ersten Pixel (10A) in der Spaltenrichtung befindet, die einheitliche Struktur aufweisen und **dadurch gekennzeichnet, dass**
die Pixelanordnungsstruktur eine Vielzahl von wiederholten Einheiten umfasst, die in der Zeilenrichtung und der Spaltenrichtung angeordnet sind, wobei jede der wiederholten Einheiten zwei erste Subpixel (11), ein zweites einheitliches Subpixel und ein drittes einheitliches Subpixel umfasst; die zwei ersten Subpixel (11) sich in einer Spaltenrichtung befinden und eine erste Subpixelgruppe ausbilden; und die erste Subpixelgruppe, das zweite einheitliche Subpixel und das dritte einheitliche Subpixel sich in einer Zeilenrichtung befinden;
wobei sich das erste Subpixel (11) in jedem des ersten Pixels (10A) und des zweiten Pixels (10B) in einem Mittelbereich des Pixels befindet und das erste Subpixel (11) in jedem des ersten Pixels (10A) und des zweiten Pixels (10B) ein grünes Subpixel ist;
wobei ein Pixelbereich, in dem sowohl das erste Pixel (10A) als auch das zweite Pixel (10B) angeordnet ist, ein rechteckiger Bereich ist, wobei das erste Subpixel (11) sowohl in jedem des ersten Pixels (10A) und des zweiten Pixels (10B) eine Mitte des rechteckigen Bereichs und einen Umgebungsbereich der Mitte in dem rechteckigen Bereich abdeckt.

2. Pixelanordnungsstruktur nach Anspruch 1, wobei das zweite Subpixel (12) und das dritte Subpixel (13) in jedem des ersten Pixels (10A) und des zweiten Pixels (10B) in der gleichen Zeile angeordnet sind.

3. Pixelanordnungsstruktur nach einem der Ansprüche 1-2, wobei sich das zweite Subpixel (12) und das dritte Subpixel (13) in jedem des ersten Pixels (10A) und des zweiten Pixels (10B) an einem Kantenbereich des Pixels befinden.

4. Pixelanordnungsstruktur nach einem der Ansprüche 1-3, wobei
sich in dem ersten Pixel (10A) eine Kante des zweiten Subpixels (12) gegenüber dem ersten Subpixel (11) und eine Kante des dritten Subpixels (13) gegenüber dem ersten Subpixel (11) in unmittelbarer Nähe zu der ersten Seite (31) des ersten Pixels (10A) befindet;
sich in dem zweiten Pixel (10B), das sich benachbart zu dem ersten Pixel (10A) in der Zeilenrichtung befindet, eine Kante des zweiten Subpixels (12) gegenüber dem ersten Subpixel (11) und eine Kante des dritten Subpixels (13) gegenüber dem ersten Subpixel (11) in unmittelbarer Nähe der dritten Seite (43) des zweiten Pixels (10B) befindet;
jeweils die erste Seite (31) des ersten Pixels (10A) und die dritte Seite (43) des zweiten Pixels (10B) auf zwei gegenüberliegenden Seiten der ersten Subpixel (11) des ersten Pixels (10A) und des zweiten Pixels (10B) angeordnet sind;
sich in dem ersten Pixel (10A) das erste Subpixel (11) innerhalb eines Bereichs zwischen der dritten Seite (33) und dem zweiten und dritten Subpixel (12, 13) befindet; und
sich in dem zweiten Pixel (10B) das erste Subpixel (11) innerhalb eines Bereichs zwischen der ersten Seite (41) und dem zweiten und dritten Subpixel (12, 13) befindet,
sich vorzugsweise die Kante des zweiten Subpixels (12) gegenüber dem ersten Subpixel (11) und die Kante des dritten Subpixels (13) gegenüber dem ersten Subpixel (11) in dem ersten Pixel (10A) mit der ersten Seite (31) überlappen; und
die Kante des zweiten Subpixels (12) gegenüber dem ersten Subpixel (11) und die Kante des dritten Subpixels (13) gegenüber dem ersten Subpixel (11) in dem zweiten Pixel (10B) mit der dritten Seite (43) überlappen.

5. Pixelanordnungsstruktur nach einem der Ansprüche 1-4, wobei:
in dem ersten Pixel (10A) ein vertikaler Abstand von einer Mitte des ersten Subpixels (11) zu der dritten Seite (33) kleiner als ein vertikaler Abstand von der Mitte des ersten Subpixels (11) zu der ersten Seite (31) ist; und
in dem zweiten Pixel (10B) ein vertikaler Abstand von einer Mitte des ersten Subpixels (11) zu der ersten Seite (41) kleiner als ein vertikaler Abstand von der Mitte des ersten Subpixels (11) zu der dritten Seite (43) ist.

6. Pixelanordnungsstruktur nach einem der Ansprüche 1-5, wobei in jedem des ersten Pixels (10A) und des zweiten Pixels (10B) eine Kante des ersten Subpixels (11), das sich benachbart zu dem zweiten Subpixel (12) und dem dritten Subpixel (13) befindet, sich in unmittelbarer Nähe zu einer zweiten geraden Linie (22) befindet, wobei die zweite gerade Linie (22) parallel zu der Zeilenrichtung und in gleichem vertikalen Abstand zu der ersten Seite (31, 41) und zu der dritten Seite (33, 43) verläuft,
sich vorzugsweise die Kante des ersten Subpixels (11), die sich benachbart zu dem zweiten Subpixel (12) und dem dritten Subpixel (13) befindet, mit der zweiten geraden Linie (22) überlappt.

7. Pixelanordnungsstruktur nach einem der Ansprüche 1-6, wobei das erste Subpixel (11), das zweite Subpixel (12) und das dritte Subpixel (13) desselben Pixels (10A, 10B) eine gleichschenklige Dreiecksverteilung ausbilden.

8. Pixelanordnungsstruktur nach einem der Ansprüche 1-7, wobei jedes des ersten Pixels (10A) und des zweiten Pixels (10B) ein rechteckiges oder quadratisches Pixel ist,
vorzugsweise in jedem des ersten Pixels (10A) und des zweiten Pixels (10B) das zweite Subpixel (12) und das dritte Subpixel (13) in der Nähe von zwei Ecken des rechteckigen oder quadratischen Pixels in der Zeilenrichtung angeordnet ist, wobei sich jeweils zwei benachbarte rechtwinklige Kanten des zweiten Subpixels (12) und zwei benachbarte rechtwinklige Kanten des dritten Subpixels (13) in unmittelbarer Nähe zu zwei benachbarten rechtwinkligen Kanten des rechteckigen oder quadratischen Pixels befinden,
sich vorzugsweise jeweils die beiden benachbarten rechtwinkligen Kanten des zweiten Subpixels (12) und die beiden benachbarten rechtwinkligen Kanten des dritten Subpixels (13) mit den beiden benachbarten rechtwinkligen Kanten des rechteckigen und quadratischen Pixels überlappen.

9. Pixelanordnungsstruktur nach einem der Ansprüche 1-8, wobei das erste Subpixel (11) auf einer rechtwinkligen Winkelhalbierenden des zweiten Subpixels (12) und des dritten Subpixels (13) positioniert ist,
vorzugsweise ein Mittelpunkt des ersten Subpixels (11) auf der rechtwinkligen Winkelhalbierenden des zweiten Subpixels (12) und des dritten Subpixels (13) angeordnet ist.

10. Pixelanordnungsstruktur nach einem der Ansprüche 1-9, wobei jedes des ersten Subpixels (11), des zweiten Subpixels (12) und des dritten Subpixels (13) ein rechteckiges oder quadratisches Subpixel ist.

11. Pixelanordnungsstruktur nach einem der Ansprüche 1-10, wobei das erste Pixel (10A) und das zweite Pixel (10B), die sich benachbart zueinander in einer Spaltenrichtung befinden, spiegelsymmetrisch sind.

12. Anzeigesubstrat, umfassend die Pixelanordnungsstruktur nach einem der Ansprüche 1-11.

## Revendications

1. Structure d'agencement de pixels, comprenant :
un premier pixel (10A) ayant un premier côté (31) et un troisième côté (33) opposé au premier côté (31), et
un second pixel (10B) ayant un premier côté (41) et un troisième côté (43) opposé au premier côté (41),
le premier pixel (10A) et le second pixel (10B) comprenant chacun :
un premier sous-pixel (11),
un deuxième sous-pixel (12), et
un troisième sous-pixel (13) ;
dans laquelle le premier pixel (10A) et le second pixel (10B) sont alternativement orientés dans un sens des rangées et un sens des colonnes ;
le premier sous-pixel (11), le deuxième sous-pixel (12) et le troisième sous-pixel (13) dans le premier pixel (10A) forment une distribution triangulaire ;
le premier sous-pixel (11), le deuxième sous-pixel (12) et le troisième sous-pixel (13) dans le second pixel (10B) forment une distribution triangulaire inversée par rapport à la distribution triangulaire dans le premier pixel (10A) ; et
le deuxième sous-pixel (12) et le troisième sous-pixel (13) dans le premier pixel (10A) sont situés sur sensiblement la même rangée, et le deuxième sous-pixel (12) et le troisième sous-pixel (13) dans le second pixel (10B) sont situés sur sensiblement la même rangée ; et
le deuxième sous-pixel (12) et le troisième sous-pixel (13) dans le premier pixel (10A) sont adjacents au deuxième sous-pixel (12) et au troisième sous-pixel (13) dans le second pixel (10B) adjacents respectivement au premier pixel (10A) dans le sens des colonnes,
le deuxième sous-pixel (12) dans le premier pixel (10A) et le deuxième sous-pixel (12) dans le second pixel (10B) adjacent au premier pixel (10A) dans le sens des colonnes sont intégrés et partagés par le premier pixel (10A) et le second pixel (10B) adjacent au premier pixel (10A) dans le sens des colonnes, de sorte que le deuxième sous-pixel (12) dans le premier pixel (10A) et le deuxième sous-pixel (12) dans le second pixel (10B) adjacent au premier pixel (10A) dans le sens des colonnes aient une structure unitaire ; et le troisième sous-pixel (13) dans le premier pixel (10A) et le troisième sous-pixel (13) dans le second pixel (10B) adjacent au premier pixel (10A) dans le sens des colonnes sont intégrés et partagés par le premier pixel (10A) et le second pixel (10B) adjacent au premier pixel (10A) dans le sens des colonnes, de sorte que le troisième sous-pixel (13) dans le premier pixel (10A) et le troisième sous-pixel (13) dans le second pixel (10B) adjacent au premier pixel (10A) dans le sens des colonnes aient la structure unitaire, et **caractérisé en ce que**
la structure d'agencement de pixels comprend une pluralité d'unités répétées disposées dans le sens des rangées et dans le sens des colonnes, chacune des unités répétées comprenant deux premiers sous-pixels (11), un deuxième sous-pixel unitaire et un troisième sous-pixel unitaire ; les deux premiers sous-pixels (11) sont dans le sens des colonnes et forment un premier groupe de sous-pixels ; et le premier groupe de sous-pixels, le deuxième sous-pixel unitaire et le troisième sous-pixel unitaire sont dans le sens des rangées ;
le premier sous-pixel (11) dans chacun des premier (10A) et second (10B) pixels est au niveau d'une zone centrale du pixel, et le premier sous-pixel (11) dans chacun des premier (10A) et second (10B) pixels est un sous-pixel vert ;
une zone de pixel dans laquelle chacun des premier (10A) et second (10B) pixels est située est une zone rectangulaire, le premier sous-pixel (11) dans chacun des premier (10A) et second (10B) pixels couvre un centre de la zone rectangulaire et une zone environnante du centre dans la zone rectangulaire.

2. Structure d'agencement de pixels selon la revendication 1, dans laquelle le deuxième sous-pixel (12) et le troisième sous-pixel (13) dans chacun du premier pixel (10A) et du second pixel (10B) sont situés sur la même rangée.

3. Structure d'agencement de pixels selo2n l'une quelconque des revendications 1 et 2, dans laquelle le deuxième sous-pixel (12) et le troisième sous-pixel (13) dans chacun du premier pixel (10A) et du second pixel (10B) sont au niveau d'une zone de bord du pixel.

4. Structure d'agencement de pixels selon l'une quelconque des revendications 1 à 3, dans laquelle
dans le premier pixel (10A), un bord du deuxième sous-pixel (12) opposé au premier sous-pixel (11) et un bord du troisième sous-pixel (13) opposé au premier sous-pixel (11) sont à proximité étroite du premier côté (31) du premier pixel (10A) ;
dans le second pixel (10B) adjacent au premier pixel (10A) dans le sens des rangées, un bord du deuxième sous-pixel (12) opposé au premier sous-pixel (11) et un bord du troisième sous-pixel (13) opposé au premier sous-pixel (11) sont à proximité étroite du troisième côté (43) du second pixel (10B) ;
le premier côté (31) du premier pixel (10A) et le troisième côté (43) du second pixel (10B) sont disposés respectivement sur deux côtés opposés des premiers sous-pixels (11) du premier pixel (10A) et du second pixel (10B),
dans le premier pixel (10A), le premier sous-pixel (11) se trouve dans une zone située entre le troisième côté (33) et les deuxième et troisième sous-pixels (12, 13) ; et
dans le second pixel (10B), le premier sous-pixel (11) se trouve dans une zone située entre le premier côté (41) et les deuxième et troisième sous-pixels (12, 13),
de préférence, le bord du deuxième sous-pixel (12) opposé au premier sous-pixel (11) et le bord du troisième sous-pixel (13) opposé au premier sous-pixel (11) dans le premier pixel (10A) chevauchent le premier côté (31) ; et
le bord du deuxième sous-pixel (12) opposé au premier sous-pixel (11) et le bord du troisième sous-pixel (13) opposé au premier sous-pixel (11) dans le second pixel (10B) chevauchent le troisième côté (43).

5. Structure d'agencement de pixels selon l'une quelconque des revendications 1 à 4, dans laquelle :
dans le premier pixel (10A), une distance verticale entre le centre du premier sous-pixel (11) et le troisième côté (33) est inférieure à une distance verticale entre le centre du premier sous-pixel (11) et le premier côté (31) ; et
dans le second pixel (10B), une distance verticale entre le centre du premier sous-pixel (11) et le premier côté (41) est inférieure à une distance verticale entre le centre du premier sous-pixel (11) et le troisième côté (43).

6. Structure d'agencement de pixels selon l'une quelconque des revendications 1 à 5, dans laquelle, dans chacun du premier pixel (10A) et du second pixel (10B), un bord du premier sous-pixel (11) adjacent au deuxième sous-pixel (12) et au troisième sous-pixel (13) est à proximité étroite d'une seconde ligne droite (22), la seconde ligne droite (22) étant parallèle au sens des rangées et à une distance verticale égale du premier côté (31, 41) et du troisième côté (33, 43). de préférence, le bord du premier sous-pixel (11) adjacent au deuxième sous-pixel (12) et au troisième sous-pixel (13) chevauche la seconde ligne droite (22).

7. Structure d'agencement de pixels selon l'une quelconque des revendications 1 à 6, dans laquelle le premier sous-pixel (11), le deuxième sous-pixel (12) et le troisième sous-pixel (13) du même pixel (10A, 10B) forment une distribution triangulaire isocèle.

8. Structure d'agencement de pixels selon l'une quelconque des revendications 1 à 7, dans laquelle chacun du premier pixel (10A) et du second pixel (10B) est un pixel rectangulaire ou carré.
de préférence, dans chacun du premier pixel (10A) et du second pixel (10B), le deuxième sous-pixel (12) et le troisième sous-pixel (13) sont situés près de deux coins du pixel rectangulaire ou carré dans le sens des rangées, avec deux bords perpendiculaires adjacents du deuxième sous-pixel (12) et deux bords perpendiculaires adjacents du troisième sous-pixel (13) respectivement à proximité étroite de deux bords perpendiculaires adjacents du pixel rectangulaire ou carré, de préférence, les deux bords perpendiculaires adjacents du deuxième sous-pixel (12) et les deux bords perpendiculaires adjacents du troisième sous-pixel (13) chevauchent respectivement les deux bords perpendiculaires adjacents du pixel rectangulaire ou carré.

9. Structure d'agencement de pixels selon l'une quelconque des revendications 1 à 8, dans laquelle le premier sous-pixel (11) est positionné sur une bissectrice perpendiculaire du deuxième sous-pixel (12) et du troisième sous-pixel (13).
de préférence, un centre du premier sous-pixel (11) est situé sur la bissectrice perpendiculaire du deuxième sous-pixel (12) et du troisième sous-pixel (13).

10. Structure d'agencement de pixels selon l'une quelconque des revendications 1 à 9, dans laquelle chacun du premier sous-pixel (11), du deuxième sous-pixel (12) et du troisième sous-pixel (13) est un sous-pixel rectangulaire ou carré.

11. Structure d'agencement de pixels selon l'une quelconque des revendications 1 à 10, dans laquelle le premier pixel (10A) et le second pixel (10B) adjacents l'un à l'autre dans un sens des colonnes sont symétriques en miroir.

12. Substrat d'affichage, comprenant la structure d'agencement de pixels selon l'une quelconque des revendications 1 à 11.
